Europäisches Patentamt

European Patent Office

Office européen des brevets

(11) Publication number: **0 401 549**
**A2**

## (12) EUROPEAN PATENT APPLICATION

(21) Application number: **90109034.0**

(22) Date of filing: **14.05.90**

(51) Int. Cl.⁵: **H01L 27/01**

(30) Priority: **09.06.89 JP 145277/89**

(43) Date of publication of application:
**12.12.90 Bulletin 90/50**

(84) Designated Contracting States:
**DE FR**

(71) Applicant: **TOSHIBA LIGHTING &
TECHNOLOGY CORPORATION**
**4-28, Mita 1-chome**
**Minato-ku Tokyo(JP)**

(72) Inventor: **Ezaki, Shiro Nishikubocho Koen**
**Haitsu Danchi 2-403**
**1-4, Nishikubo-Cho, Hodogaya-Ku**
**Yokohama-shi, Kanagawa-Ken(JP)**

(74) Representative: **Blumbach Weser Bergen
Kramer Zwirner Hoffmann Patentanwälte**
**Radeckestrasse 43**
**D-8000 München 60(DE)**

(54) **Thick film hybrid circuit board device and method of manufacturing the same.**

(57) A thick film hybrid circuit board device is formed by laminating a first layer (12) and a second layer (13a, 13b) on an insulative base board (11). The second layer overlapping the insulative base board (11) and the first layer (12) has a recessed portion (14) located at cross portion where a peripheral edge portion of the first layer (12) and a peripheral edge portion of the second layer are crossed. The recessed portion is formed in the shape of being recessed inwardly of the second layer. Bleedings generated from the second layer consisting of paste are held in the recessed portion, so that short circuit accidents caused by the bleedings mutually combined are effectively prevented.

F I G. 1

EP 0 401 549 A2

## BACKGROUND OF THE INVENTION

This invention relates to a thick film hybrid circuit board device formed by utilizing screen printing process and to a method of manufacturing the same and, more particularly, to a thick film hybrid circuit board device having a high quality and a compact structure and also relates to a method of manufacturing the thick film circuit board device of this character.

The thick film hybrid circuit board device of conventional type has a construction having a plurality of circuit forming materials laminated on an insulative baseboard. For example, a thick film hybrid circuit board device having a resistor element as a circuit element is manufactured by printing, e.g., screen printing a first layer as a resistor on the insulative base board and by laminating a second layer on both peripheral edge portions of the first layer as a pair of electrodes.

Resistors and electrodes are usually formed by printing circuit forming materials on a surface of the insulative base board by utilizing a screen printing process to form thick films.

The thick films printed to the base board are then fired under the predetermined condition to form hardened resistors and electrodes.

In the screen printing process, a screen plate having numerous micro holes on entire surface thereof is prepared as a printing mold, in which holes provided in an outside area of a predetermined circuit pattern formed by photomechanical processing are broken to be plugged.

The screen printing process is utilized as a method of forming a circuit film by squeezing a paste-like circuit forming material to the base board through the holes provided inside area of the circuit pattern.

The method of manufacturing the thick film hybrid circuit board device will be explained hereunder more concretely. First, a resistive paste is screen printed to the base board to form a layer. A printed resistive paste is then fired to form a resistive layer as a first layer. Secondly, a conductive paste for forming a second layer is printed on both the upper end surfaces of the resistive layer, and the printed conductive paste is fired to form a pair of electrode layers as a second layer.

However, in this type of the conventional thick film hybrid circuit board device, stagger portions exist between the upper surface of the insulative base board and a cross portion where peripheral edge portion of the resistive layer and that of a pair of electrode layers are mutually crossed.

Due to existence of the stagger portions, a part of each of the electrode layers formed of conductive paste will spread from internal edge portion thereof toward the other electrode layer, resulting in the formation of bleedings which is outstanding toward the other electrode layer.

For this reason, in a case where a distance between a pair of electrode layers become narrower as an integration degree of the thick film hybrid circuit board device is more increased, the distance between the two electrode layers is substantially reduced by the bleedings consisting of the paste, so that serious problem is encountered, that is, the resistance value of the resistive layer includes a significant error.

Moreover, in a case where the paste bleedings generated from the electrode layers are large, the bleedings are finally mutually combined to form a bridge portion, causing a problem of taking place short circuit accidents between the pair of electrode layers.

Furthermore, during a trimming process for adjusting a resistance of the resistive layer, it becomes more difficult to set a starting point at which trimming operation starts because the distance between the pair of electrode layers is extremely reduced.

## SUMMARY OF THE INVENTION

An object of the present invention is to substantially eliminate defects or drawbacks encounted to the prior art described above and to provide a thick film hybrid circuit board device which has a simple construction for enabling to effectively prevent the variation of electrical characteristics of the first layer caused by bleedings generated from a paste of the second layer and which is substantially free from short circuit accidents which may be taken place between the pair of second layers which are oppositly located, and also to provide a method of manufacturing this type of circuit board device.

This and other objects can be achieved according to this invention in one aspect by providing a thick film hybrid circuit board device which comprises an insulative base board as a base plate; a first layer formed on the insulative base board; and a second layer formed so as to be overlapped with a surface of the first layer and a surface of the insulative base board, the second layer is provided with an inwardly recessed portion formed at a cross portion where a peripheral edge portion of the first layer and a peripheral edge portion of the second layer are crossed.

In another aspect of this invention, there is provided a method of manufacturing a thick film hybrid circuit board device, the method comprises the steps of: preparing an insulative base board as a base plate and at least two kinds of paste-like circuit forming materials; screen printing one paste-like circuit forming material on a surface of the insulative base board by utilizing a screen printing process to form one layer; firing the thus formed one layer to form as a first layer; screen printing another paste-like circuit forming material on surfaces of the first layer and the insulative base board by utilizing the screen printing process so as to be overlapped with the first layer and the insulative base-board to form another layer having a portion recessed inwardly of the another layer in which the recessed portion is located at a cross portion where a peripheral edge portion of the first layer and a peripheral edge portion of the another layer are crossed; and firing the thus formed another layer to form as a second layer.

According to the construction of the present invention described above, when a second layer consisting of paste is screen printed by utilizing a screen printing process on an upper surface of a first layer formed on a insulative base board, a recessed portion which is recessed inwardly of the second layer is formed at a cross portion where a peripheral edge portion of the first layer and a peripheral edge portion of the second layer are crossed.

However, as the recessed portion of the second layer is almost completely filled up with bleedings generated from paste of the second layer, after the second layer is fired, the peripheral edge portion of the second layer is formed into almost original shape having no recessed portions.

Therefore, according to the present invention, variations of electrical characteristics of the first layer caused by bleedings generated from the second layer formed of paste and electrical short circuit accidents caused by the bleedings bonded mutually are effectively prevented.

## BRIEF DESCRIPTION OF THE DRAWINGS

In the accompanying drawings:

Fig. 1 is a partial plan view showing an embodiment of thick film hybrid circuit board device according to this invention;

Fig. 2 is a cross-sectional view taken along the line II-II of Fig. 1;

Figs. 3 and 4 are partial plan views showing another embodiments of this invention, respectively;

Fig. 5 is a partial perspective view showing a conventional thick film hybrid circut board device;

Fig. 6 is a cross-sectional view taken along the line VI-VI of Fig. 5;

Fig. 7 is a partial plan view showing a condition where paste bleedings are generated in the conventional thick film hybrid circuit board device shown in Fig. 5.

## DESCRIPTION OF THE PREFERRED EMBODIMENTS

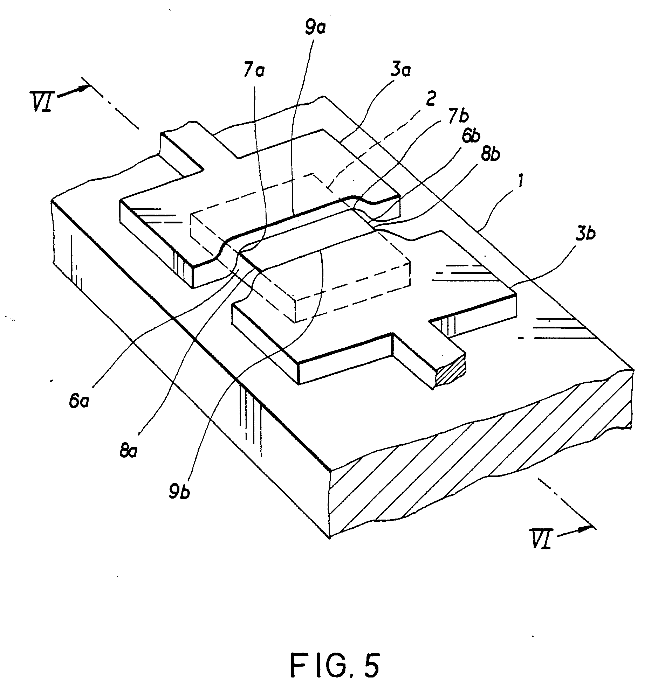

In advance of the description of preferred embodiments according to the present invention, conventional technology or prior art will be described hereunder with reference to Figs. 5 to 7 for a better understanding of the present invention.

Conventional thick film hybrid circuit board device is manufactured in the following manner.

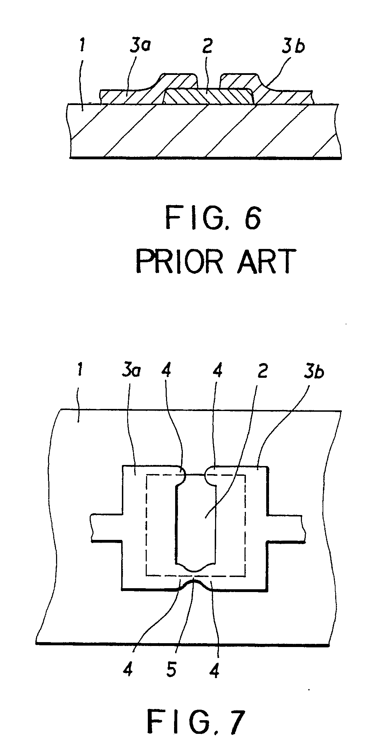

Referring to Figs. 5 and 6, first, resistive paste containing, for example, such as ruthenium oxide ($RuO_2$) is screen printed in the shape of a rectangle on an upper surface of an insulative base board 1 made of ceramic such as alumina ($Al_2O_3$) by utilizing a screen printing process to form a layer. The layer consisting of the resistive paste is then fired at temperature of 800 to 900° C more preferably at about 850° C under the condition of atmospheric pressure to form a resistive layer 2 as a first layer.

Next, conductive paste containing conductive material such as copper(Cu), silver (Ag) or gold (Au) is screen printed in the shape of a rectangle on the upper surfaces of both right and left edges of the resistive layer 2 by utilizing a screen printing process. The conductive paste is then fired at a temperature of 500 to 700 ° C more preferably at about 600° C to form a pair of bilateral electrode layers 3a and 3b as a second layer.

However, in case of the conventional thick film hybrid circuit board device of the character described in conjunction with Fig. 5, stagger portions 6a and 6b exist between an upper surface of the insulative base board 1 and each of cross portions 7a and 7b where each of peripheral edge portions 8a and 8b of the resistive layer 2 and each of peripheral edge portions 9a and 9b of the electrode layers 3a and 3b are mutually crossed.

Due to the existence of these stagger portions 6a and 6b a part of one of the electrode layers 3a and 3b formed of the conductive paste will spread from the internal edge portion thereof toward the other electrode layer. Consequently, as shown in Fig. 7, bleedings 4 and 4 are caused in directions towards the mutually opposing end edge portions of the respective electrode layers 3a and 3b.

For this reason, in a case where a distance between a pair of bilateral electrode layers 3a and 3b becomes narrower, for example, about 0.254 mm as the thick film hybrid circuit board device is more miniaturized, the distance between the bilateral electrode layers 3a and 3b is substantially reduced by the bleedings, thus providing serious problem. That is, the resistance value of the resistive layer 2 includes a significant error.

Moreover, in the case that the paste bleedings 4 and 4 generated from the electrode layers 3a and 3b are large as shown in Fig. 7, the bleedings 4 and 4 may be finally combined each other to form a bridge portion 5 causing a problem of taking place short circuit accidents between the pair of electrode layers 3a and 3b.

Furthermore, during trimming process for adjusting a resistance of the resistive layer 2, it becomes more difficult to set a starting point at which trimming operation shall be started because the distance between the pair of electrode layers 3a and 3b is reduced.

The present invention conceived for solving the problem of the prior art described above will be described hereunder.

The inventor has eagerly studied and found that if an amount of bleedings generated from a paste of electrode layers is previously estimated and recessed portions having volumes which are equivalent to the amount of bleedings, respectively, are formed at each of the electrode layers, the bleedings are received into the recessed portions and, consequently, the recessed portions are filled up with the bleedings. The electrode layers having no outstanding of bleedings are hence formed properly into an original shape. The present invention is essentially based on these findings.

EMBODIMENTS

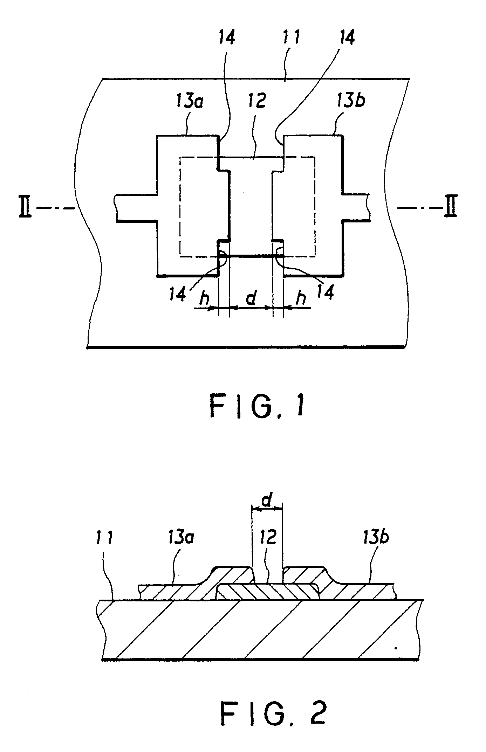

The embodiments in accordance with the present invention will be described below in more detail with reference to Figs. 1 to 4.

Fig. 1 shows a partial plan view of one embodiment of a thick film hybrid circuit board device according to this invention. In Fig. 1, a resistive layer 12 as a first layer is formed on an insulative base board 11 formed of ceramics in the shape of a rectangle. At bilateral edge portions of the resistive layer 12 as shown in Fig. 2, a pair of bilateral electrode layers 13a and 13b are formed on the resistive layer 12 as a second layer of which a peripheral portion is overlapped to the insulative base board 11. A resistance value of the resistant layer 12 can be set to a desired value by controlling a distance (d) between the bilateral electrode layers 13a and 13b.

On the other hand, a recessed portion 14 having a rectangular shape and which is recessed inwardly of each of the electrode layers 13a and 13b is formed at each of four cross portions where peripheral edge portions (corresponding to both upper and lower side portions in Fig. 1) of the resistive layer 12 and peripheral edge portions (corresponding to both end surfaces located oppositely in Fig. 1) of the pair of electrode layers 13a and 13b are crossed.

Due to existence of stagger portions between each of the electrode layers 13a and 13b and the insulative base board 11, the bleedings 4 and 4 generated from both electrode layers consisting of paste as shown in Fig. 7 spread from one electrode layer toward the other electrode layer mutually located in the opposing condition. Therefore, an amount volume of the bleedings 4, 4 --- is previously estimated and each of the recessed portions 14, 14 --- having a volume which is equivalent to the amount of each of the bleedings 4 is formed at each of the electrode layers 13a and 13b.

Namely, the volume of the recessed portion 14 is set to the value which is equivalent to the amount of bleeding 4 generated from the electrode layers 13a and 13b as a second layer printed on the resistive layer 12 as a first layer.

Accordingly, when the pair of electrode layers 13a and 13b are screen printed on the surfaces of the resistive layer 12 and the insulative base board 11 by utilizing, for example, the screen printing process, the conductive paste of each of the electrode layers 13a and 13b will spread in each of recessed portion 14, 14 - - formed in the electrode layers 13a and 13b to form bleedings.

However, almost part of the bleedings is received into the recessed portions 14, 14 - -. Consequently, the recessed portion 14, 14 - - are almost filled up with the bleedings. Accordingly, the electrode layers 13a and 13b each having a plane and parallel edge portions are obtained, and the electrode layers 13a and 13b are finally formed so as to be close to the original shape having no recessed portions shown in Fig. 5.

For example, in the case of that the distance (d) is about 0.254 mm (0.01 inch), a cutout depth (h) of each of the recessed portions 14 and 14 may be set to about 0.05 mm respectively, and the total amount of the cutout depth is set to about 0.1 mm, so that each of the recessed portions 14, 14 --- will be filled up with the bleedings generated from the conductive paste of each of the electrode layers 13a and 13b. As the result, both opposite edge surfaces of the electrode layers 13a and 13b become almost parallel with each other, and the distance (d) can be exactly set to a desired value of about 0.254 mm, whereby a predetermined resistance value is secured.

Next, one embodiment of the method of manufacturing the thick film hybrid circuit board device constructed in the manner described above will be explained hereunder.

First, an insulative base board made of ceramic such as alumina ($Al_2O_3$) is prepared as a base plate, and at least two kinds of circuit forming materials for forming circuit·elements such as resistor, electrode or wirings are prepared in the state of paste which is made able to flow through the micro holes of the screen during screen printing process.

In this embodiment, a resistive paste containing, for example, ruthenium oxide ($RuO_2$) powder and a conductive paste containing copper (Cu) powder are prepared as circuit forming materials for forming resistors and electrodes respectively. Secondly, the resistive paste is screen printed by utilizing the screen printing process through the screen plate on the insulative base board 11 to form a printed resistive layer in the shape of such asa rectangle. Thirdly, the printed resistive layer is fired at a temperature of 800 to 900°C more preferably at about 850°C under an atmospheric condition to form a resistive layer 12 as a first layer.

Fourthly, the conductive paste is screen printed on both right and left (in Fig. 1) edge portions of the resistive layer 12 so as to form a pair of bilateral electrode layers 13a and 13b as a another layer by utilizing the screen printing process.

At the screen printing operation, the recessed portion 14 is formed through a screen plate at each of four cross portions respectively where peripheral edge portion of the resistive layer 12 (corresponding to both upper and lower side portions in Fig. 1) and peripheral edge portions of the electrode layers 13a and 13b are mutually crossed orthogonally. The screen plate for making a circuit pattern in previously constructed so as to form the recessed portions 14 and 14.

However, after the screen printing operation, each of the recessed portions 14, 14 --- is substantially completely filled up with the bleedings generated from a pair of electrode layers 13a and 13b consisting of conductive paste, whereby the recessed portions 14, 14 --- are formed into flat shape.

Then, the printed electrode layers 13a and 13b formed of conductive paste are fired at the temperature of 500 to 700°C more preferably at about 600°C in $N_2$ gas atmosphere, for example, to form a pair of bilateral electrode layers 13a and 13b respectively.

According to this embodiment, the distance between the pair of bilateral electrode layers 13a and 13b is not to become narrower and is set to a predetermined value, so that the resistance value of the resistive layer 12 can be set precisely to a desired value.

In addition, electrical short circuit accidents taking place in a pair of electrode layers 13a and 13b caused by the formation of a bridge portion 5 as shown in Fig. 7, which is formed by the bleedings 4 combined mutually are effectively prevented.

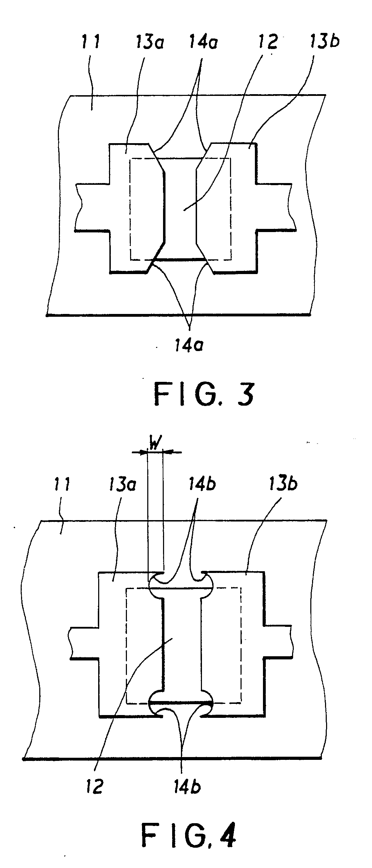

In the embodiment described above, an explanation was accomplished in a case where the recessed portion 14, and 14 of the pair of bilateral electrode layers 13a and 13b are formed as cutout portions in the shape of a rectangle. However, the present invention is not limited to the described embodiment. For example, as shown in Fig. 3, recessed portions 14a may be formed by cutting off the electrode layers 13a and 13b so as to have a shape of a triangle. In this case, as only one straight cutting line extending diagonally shall be drawn, it becomes easy to design a pattern for making the recessed portion.

In addition, as shown in Fig. 4, recessed portions 14b may also be formed by cutting off the electrode layers 13a and 13b in a semi-circular shape. In this case, each of the electrode layers 13a and 13b is set respectively so as to match an edge portion of the resistive layer 12 with a center line of the semi-circular shape. In other words, each of the electrode layers 13a and 13b is set so as to maximize a length (W) of the edge portion being cut off by the semi-circular.

Accordingly, it becomes easy to set an initial locating point of the electrode layers 13a and 13b against the resistive layer 12.

Moreover, in the embodiment described above, the method of manufacturing of circuit board device having a resistive layer 12 as a first layer and having electrode layers 13a and 13b as a second layer is introduced. However, the present invention is not limited to this embodiment.

The present invention can be generally adapted in the same manner to all kinds of this thick film hybrid circuit board device formed by laminating more than three circuit element material layers.

It is to be understood that the present invention is not limited to the preferred embodiment described above and many other modifications and changes may be made without departing from the scope of the appended claim.

**Claims**

1. A thick film hybrid circuit board device having an insulative base board as a base plate, a first layer formed on said insulative base board, a second layer formed so as to be overlapped with a surface of said first layer and a surface of said insulative base board, said thick hybrid circuit board device being characterized in that said second layer (13a or 13b) is provided with an inwardly recessed portion (14) formed at a cross portion where a peripheral edge portion of said first layer (12) and a peripheral edge portion of said second layer (13a or 13b) are crossed.

2. A thick film hybrid circuit board device according to claim 1, wherein said recessed portion (14) is formed by cutting off said second layer (13a or 13b) substantially in the the shape of a triangle.

3. A thick film hybrid circuit board device according to claim 1, wherein said recessed portion (14) is formed by cutting off said second layer (13a or 13b) in substantially semi-circular shape.

4. A method of manufacturing a thick film hybrid circuit board device characterized bY comprising the steps of:

preparing an insulative base board (11) as a base plate and at least two kinds of paste-like circuit forming materials;

screen printing one paste-like circuit forming material on a surface of insulative base board (11) to form one layer;

firing the thus formed one layer to form a first layer (12);

screen printing another paste-like circuit forming material on surfaces of the first layer (12) and the insulative base board (11) so as to be overlapped with said first layer (12) and said insulative base board (11) to form another layer having a portion recessed inwardly of the another layer and located at a cross portion where a peripheral edge portion of said first layer (12) and a peripheral edge portion of the another layer are crossed; and

firing the thus formed another layer to form a second layer (13a or 13b).

5. A method of manufacturing a thick film hybrid circuit board device according to claim 4, wherein one and another paste-like circuit forming materials are printed by utilizing a screen printing process.

6. A method of manufacturing a thick film hybrid circuit board device according to claim 4, wherein a volume of the recessed portion (14) is set to a value which is equivalent to an amount of bleedings (4) generated from said another layer printed on said first layer (12).

F I G. 1

F I G. 2

EP 0 401 549 A2

FIG. 3

FIG. 4

FIG. 5

PRIOR ART

FIG. 6
PRIOR ART

FIG. 7
PRIOR ART